# EUROPEAN PATENT APPLICATION

(11) **EP 2 299 794 A1**
(43) Date of publication of application: **23.03.2011**
(21) Application number: 09170419.7
(22) Date of filing: 16.09.2009
(51) Int. Cl.: H05K 7/20

(54) **Frequency converter**

(71) Applicant: ABB Research Ltd, 8050 Zürich (CH)
(72) Inventor: Agostini, Francesco, 4800, Zofingen (CH); Yesin, Berk, 8038, Zürich (CH); Agostini, Bruno, 8953, Dietikon (CH)
(74) Representative: Holmström, Stefan Mikael

(57) **Abstract**

The invention relates to a frequency converter (1) comprising a cooling apparatus for cooling components of said frequency converter (1), said cooling apparatus comprising: a first heat transfer element (9) for receiving a heat load from at least one primary component and a second heat transfer element (8) for receiving fluid flowing through a cooling channel, and for transferring said heat load to the surroundings. In order to obtain an efficient cooling apparatus, said cooling apparatus comprises a third heat transfer element (12) for transferring a heat load from an air flow within said frequency converter via said third heat transfer element (12) to said fluid, and a fan (16) for generating said air flow passing via said third heat transfer element (12) and via at least one secondary component of said frequency converter (1).

## Description

### BACKGROUND OF THE INVENTION

### FIELD OF THE INVENTION

This invention relates to a frequency converter and in particular to a cooling apparatus of a frequency converter.

### DESCRIPTION OF PRIOR ART

A frequency converter comprises several components which during use of the frequency converter generate heat. Consequently, prior art frequency converters are provided with solutions for transferring the generated heat to the surroundings of the frequency converter.

The components of a frequency converter can be classified into primary components, which generate a large heat load or which for some other reason require efficient cooling, and secondary components, which generate a small heat load or whose cooling is not of critical importance. Typically the primary components are attached to a first heat transfer element, which transfers the heat load of the primary components to a fluid flowing through a cooling channel. The fluid is cooled down with a second heat transfer element, which transfers the heat load from said fluid to the surroundings of the frequency converter.

The secondary components, on the other hand, are not attached to any heat transfer element. Therefore, an additional system is provided for cooling down these secondary components.

A drawback with the prior art solution is the need of a separate system for cooling down the secondary components.

### SUMMARY OF THE INVENTION

An object of the present invention is to solve the above mentioned drawback and to provide a new, cost-efficient, simple and efficient solution for providing a frequency converter with sufficient cooling. This object is achieved with a frequency converter as defined in independent claim 1.

An efficient cooling apparatus is achieved when a third heat transfer element is connected to a cooling channel for transferring a heat load of an air stream passing via the third heat transfer element to a cooling fluid. In this way, a separate system for cooling down the secondary components is no longer necessary.

### BRIEF DESCRIPTION OF THE DRAWINGS

In the following, the present invention will be described in closer detail by way of example and with reference to the attached drawings, in which

Figure 1 is a block diagram of an embodiment of a frequency converter,

Figure 2 illustrates a cooling apparatus of a frequency converter, and

Figure 3 illustrates parts of the cooling apparatus arranged inside a housing of a frequency converter.

### DESCRIPTION OF AT LEAST ONE EMBODIMENT

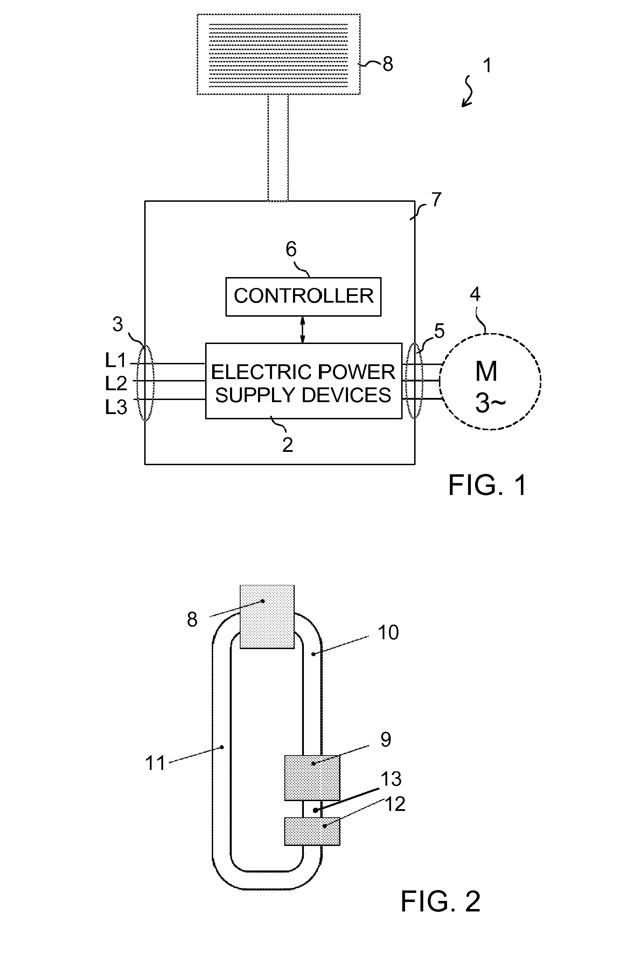

Figure 1 is a block diagram of an embodiment of a frequency converter 1. The frequency converter of Figure 1 comprises electric power supply devices 2 which are connected to an electric network via an interface 3 and to a consumption device 4 (such as an electric motor) via an output 5. The electric power supply devices 2 supply electric power to the consumption device 4 under the control of a controller 6. According to prior art, the electric power supply devices 2 may include e.g. a rectifier, an intermediate circuit for filtering by a low-pass filter a pulsating direct voltage received from the rectifier or for converting such a voltage into direct current by a smoothing choke, and an inverter which converts the direct current of the intermediate circuit into an alternating current of a desired frequency.

The controller 6 may include a memory and a processor which, on the basis of parameters and a computer program stored in the memory, controls the electric power supply devices 2. The frequency converter may also include other parts, such as an operation panel provided with a display and a keypad. However, no such operation panel is necessary in all embodiments. Instead of a fixed operation panel, the frequency converter may be connected to a separate operation panel or, alternatively, to a separate display and keypad while the programs and parameters are stored in the memory of the controller.

In order to transfer heat generated by the components of the frequency converter to the surroundings, the frequency converter comprises a first heat transfer element arranged inside a housing 7 of the frequency converter 1, and a second heat transfer element 8 arranged at a distance from the first heat transfer element. In Figure 1 the second heat transfer element is arranged outside the housing 7. Heat generated by components inside the housing 7 is transferred by the first heat transfer element to a fluid, which is passed to the second heat transfer element 8, which transfers the heat from the fluid to the surroundings of the frequency converter 1.

Figure 2 illustrates a cooling apparatus of a frequency converter, such as of the frequency converter 1 of Figure 1.

The components of the frequency converter 1 are classified into primary components, which generate a large heat load or which for some other reason require efficient cooling, and secondary components, which generate a small heat load or whose cooling is for some other reason not of critical importance. Examples of such primary components are electronic circuits generating a large heat load or which require efficient cooling in order to ensure that their temperature does not reach a level high enough for malfunctions to occur. In Figure 1, such primary components are attached to a first heat transfer element 9. The first heat transfer element is via a first part of a cooling channel 10 connected to a second heat transfer element 8. Heat generated by the primary components attached to the first heat transfer element is therefore transferred by fluid flowing in the cooling channel to the second heat transfer element 8.

The second heat transfer element 8 is arranged at a distance from said first heat transfer element 9. The distance should be sufficient to ensure that the heat load transferred by the second cooling element 8 from the fluid in the cooling channel 10 to the surroundings does not create an additional heat load for the components of the frequency converter. Preferably, the second heat transfer element 8 is arranged outside the housing 7 of the frequency converter, as illustrated in Figure 1, though it is possible in some embodiments to arrange the second heat transfer element 8 inside of the housing 7 of the frequency converter.

The cooling apparatus of Figure 2 comprises a third heat transfer element 12, which via a second part 11 of the cooling channel receives fluid that has been cooled down by the second heat transfer element 8. The third heat transfer element 12 is used for cooling down secondary components arranged in the housing 7 of the frequency converter. Efficient cooling down of these secondary components is not as critical as for the primary components. Therefore, these components are arranged in an airflow, which is cooled down by the third heat transfer element 12, by transferring the heat load from the airflow to the fluid circulating in the cooling channel.

The third heat transfer element 12 is connected via a third part 13 of the cooling channel to the first heat transfer element 9. The fluid reaching an input of the first heat transfer element 9 is therefore not as cool as the fluid passed on from the second heat transfer element 8 into the second part 11 of the cooling channel. However, a raise in the temperature of the fluid which occurs at the third heat transfer element 12 is relatively small, and therefore the temperature of the fluid is still low enough in order to provide efficient cooling for the first heat transfer element 9 and the primary components attached thereto.

In a preferred embodiment, the first heat transfer element 9 comprises an evaporator which evaporates the cooling fluid. The vapour passed on from the first heat transfer element 9 to the second heat transfer element 8 via the first part of the cooling channel 10 is brought back into a liquid state by a condenser of the second heat transfer element 8. The second heat transfer element 8 therefore passes on the cooling fluid as liquid under saturation conditions, or generally liquid with a sub-cooling, to the third heat transfer element 12. The third heat transfer element 12 transfers heat from the passing air stream to the cooling fluid, which results in removal of the sub-cooling of the cooling fluid (in a liquid state). The cooling fluid reaching the first heat transfer element 9 via the third part 13 of the cooling channel will therefore have conditions varying from a sub-cooled liquid to a saturated liquid with a small vapor quality. In a solution like this, it is not necessary to utilize any pumps for passing on the cooling fluid in the cooling channel, provided that the first heat exchanger with the evaporator is physically arranged at a lower level than the second heat exchanger with the condenser. It is, however, possible to utilize a pump for circulating the cooling fluid if necessary.

In Figure 2 the different parts 10, 11 and 12 of the cooling channel have been illustrated by way of example. Their location and shape may in practical implementations be different. One alternative is that the second part 11 of the cooling channel is coaxial with the first part 10 of the cooling channel.

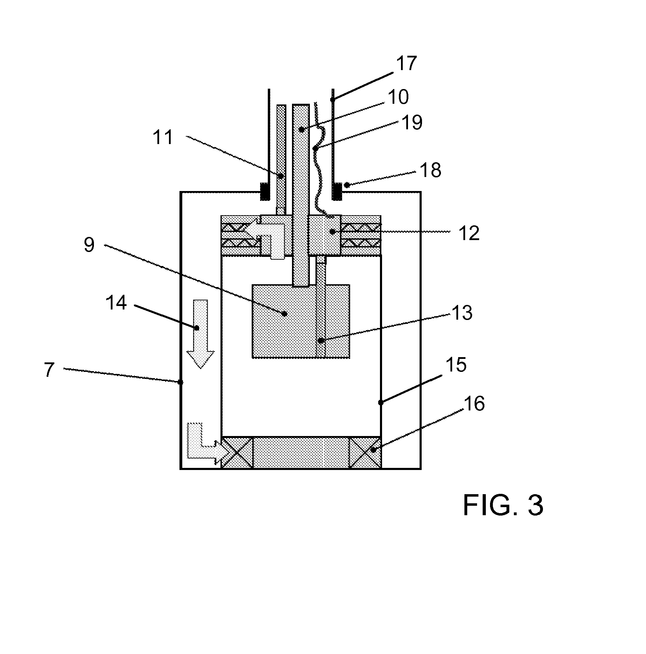

Figure 3 illustrates parts of the cooling apparatus arranged inside a housing of a frequency converter. The parts illustrated in Figure 3 can be utilized in the cooling apparatus of Figure 2 in order to cool down the frequency converter of Figure 1.

In Figure 3, an internal air flow 14 which is sealed off from the surroundings of the frequency converter is generated inside the housing 7. In order to generate the air flow, a fan 16 is in this example arranged at the bottom of the housing such that it directs the airflow directly upwards into a compartment 15 containing secondary components. The fan can, however, be arranged in an other location and directed in an alternative direction. These secondary components, and also possible secondary components located in a space between the walls of the housing 7 and the walls of the cabinet 15, are therefore cooled down by the air flow. The direction of the air flow can naturally be opposite to that shown in the Figure.

The third heat transfer element 12 is arranged in an upper part of the enclosure 15. In the example of Figure 3, the third heat transfer element 12 is illustrated as an annular type cooler, transferring heat from the air stream to a cooling fluid inside the third heat transfer element 12. The temperature of the air stream can therefore, despite the closed circulation, be kept at a sufficiently low level. No need exists to allow air from the outside of the housing 7 into the housing 7 for cooling purposes. Only a connecting pipe 17 is needed to the second heat transfer element 8 located outside the housing 7. This pipe 17 can be sealed off by a gland 18, and it can be dimensioned to provide a sufficient space for both the cooling channel and possible electrical cables 19.

In the example of Figure 3, the first heat transfer element 9 and the primary components attached thereto are also arranged in the cabinet 15. However, this is not necessary in all embodiments, as it is also possible to arrange the first heat transfer element 9 and the primary components outside the cabinet 15.

A first pipe works as a first part 10 of the cooling channel and passes on the cooling fluid from the first heat transfer element 9 to the second heat transfer element 8. In case of an evaporator, the cooing fluid can be passed on as vapor to the second heat transfer element 8.

A second pipe works as a second part 11 of the cooling channel, passing on the cooling fluid from the second heat transfer element 8 to the third heat transfer element 12, which in Figure 3 is an annular cooler. The cooling fluid received by the annular cooler may be a sub-cooled liquid.

Finally a third pipe works as a third part 13 of the cooling channel, which passes on the cooling fluid from the third heat transfer element 12 to a bottom level of the first heat transfer element 9.

It is to be understood that the above description and the accompanying figures are only intended to illustrate the present invention. It will be obvious to a person skilled in the art that the invention can be varied and modified without departing from the scope of the invention.

## Claims

1. A frequency converter (1) comprising:
an interface (3) for connecting said frequency converter to an electric network,
an output (5) for supplying electricity to a consumption device (4),
a controller (6) for controlling said supply of electricity, and
a cooling apparatus for cooling components of said frequency converter (1), said cooling apparatus comprising:
a first heat transfer element (9) for receiving a heat load from at least one primary component attached to said first heat transfer element (9), and for transferring said heat load to a fluid flowing through a first part (10) of a cooling channel, and
a second heat transfer element (8) arranged at a distance from said first heat transfer element (9) and connected to said first part (10) of the cooling channel for receiving said fluid flowing through said cooling channel, and for transferring said heat load from said fluid to surroundings of said frequency converter (1), **characterized in that** said cooling apparatus comprises:
a third heat transfer element (12) which is connected to said cooling channel for transferring a heat load from an air flow within said frequency converter to said fluid, and
a fan (16) for generating said air flow passing via said third heat transfer element (12) and via at least one secondary component of said frequency converter (1), which secondary component is not attached to said first heat transfer element (9), for transferring heat from said at least one secondary component via said third heat transfer element (12) to said fluid.

2. The frequency converter of claim 1, **characterized in that** said third heat transfer element (12) is connected to a second part (11) of said cooling channel for receiving fluid from said second heat transfer element (8), and for passing said fluid via a third part (13) of said cooling channel to said first heat transfer element (9).

3. The frequency converter of claim 1 or 2, **characterized in that** said third heat transfer element (12) and said fan (16) are arranged in a housing (7) of said frequency converter and sealed off from the surroundings of said frequency converter (1) in order to obtain an internal air flow in said housing (7).

4. The frequency converter of claim 3, **characterized in that** said first heat transfer element (9) and said at least one primary component are also arranged in said housing (7), and
said second heat transfer element (8) is arranged outside said housing (7).

5. The frequency converter according to one of claims 1 to 4, **characterized in that**
said first heat transfer element (9) comprises an evaporator which is connected by a first part of the cooling channel (10) consisting of a first pipe, to said second heat transfer element (8) for feeding vapour to said second heat transfer element (8),
said second heat transfer element (8) comprises a condenser for condensing said vapour to a liquid phase, and for feeding said liquid by a second part (11) of the cooling channel, consisting of a second pipe, to said third heat transfer element (12), and
said third heat transfer element (12) is connected by a third part (13) of said cooling channel, consisting of a third pipe, to a bottom level of said first heat transfer element (9) for introducing said liquid to said first heat transfer element (9).

6. The frequency converter according to claim 5, **characterized in that** said first heat transfer element (9) is arranged on a lower level than said second heat transfer element (8) in order to facilitate transfer of vapour from said evaporator to said condenser and transfer of liquid from said condenser to said evaporator without a pump.

7. The frequency converter according to claim 5 or 6, **characterized in that** said condenser is arranged to condense said vapour to a sub-cooled liquid.

8. The frequency converter according to one of claims 5 to 7, **characterized in that** said liquid is introduced from the third heat transfer element (12) to the first heat transfer element (9) as saturated liquid or at small vapor quantities.
